# DEMANDE DE BREVET EUROPEEN

(11) **EP 4 600 402 A1**
(43) Date de publication de la demande: **13.08.2025**
(21) Numéro de dépôt: 24215619.8
(22) Date de dépôt: 27.11.2024
(51) Int. Cl.: C23C 16/30, C23C 16/455, C23C 28/00, C01G 39/06, C23C 16/56, H01L 21/02, C23C 30/00

(54) **PROCÉDÉ DE DÉPÔT D'UNE COUCHE MINCE DE SULFURE D'UN ALLIAGE DE MÉTAUX DE TRANSITION DE GRUOPE 5 ET 6, OU D'UNE DE SES HÉTÉROSTRUCTURES**

(30) Priorité: 06.12.2023 FR 2313672
(71) Demandeur: Commissariat à l'Energie Atomique et aux Energies Alternatives, 75015 Paris (FR)
(72) Inventeur: CADOT, Stéphane, 38054 GRENOBLE CEDEX 09 (FR)
(74) Mandataire: Cabinet Beaumont

(57) **Abrégé**

La présente description concerne un procédé de dépôt en phase vapeur d'une couche en sulfure d'un métal de transition par ALD selon le cycle suivant :
- exposer un substrat à un précurseur du métal de transition, moyennant quoi une couche intermédiaire est formée,
- purger le réacteur,
- exposer la couche intermédiaire à un précurseur du soufre,
- purger le réacteur,

le substrat étant à une température comprise entre 20°C et 250°C lors du cycle,
Le cycle pouvant être répété plusieurs fois avec les mêmes précurseurs ou avec des précurseurs différents,
le précurseur du métal de transition étant choisi parmi les oxyhalogénures de molybdène, les oxyhalogénures de tungstène, les halogénures de vanadium, les halogénures de niobium et les halogénures de tantale.

## Description

### Domaine technique

La présente description concerne de façon générale le dépôt de couches minces de sulfures de métaux de transition, notamment les couches minces de sulfure de molybdène, tungstène, vanadium, niobium ou tantale et ou d'un de leurs alliages. De telles couches sont particulièrement intéressantes dans l'industrie microélectronique.

### Technique antérieure

Les dichalcogénures de métaux de transition (ou TMDs pour 'Transition Metal Dichalcogenides' en anglais), suscitent actuellement un grand intérêt en raison de leurs propriétés optoélectroniques uniques lorsqu'ils sont isolés à l'état d'une ou quelques monocouches atomiques, et de leur potentiel pour la miniaturisation et la diversification fonctionnelle des composants électroniques. En particulier l'utilisation de TMDs semiconducteurs tels que MoS₂ et WS₂ permettrait d'aller plus loin dans la miniaturisation des transistors en offrant un meilleur contrôle électrostatique que le silicium sur des dimensions de canaux inférieures à 10 nm.

La réalisation de tels composants est aujourd'hui limitée par la difficulté à intégrer le matériau TMD sans dégrader sa structure ou altérer ses propriétés. La structure lamellaire des TMD et la faible adhérence qui en découle génèrent également de nombreuses problématiques d'intégration liées à la grande complexité des étapes de lithographie. Dans ce contexte, il apparait important de développer des méthodes de dépôt de TMDs permettant leur déploiement dans des architectures 3D (par opposition à la stratégie qui consiste à faire croître le TMD sur un substrat dédié puis à le transférer sur une structure planarisée), afin de pouvoir protéger le matériau TMD tout au long des étapes d'intégration et garantir son intégrité. Un autre point critique dans la réalisation de dispositifs à base de TMD semiconducteurs est la difficulté à réaliser des contacts électriques performants.

Les TMD semi-métalliques tels que VSₓ (notamment VS₂, V₃S₄ et V₅S₈ et tous les autres composés d'auto-intercalation de VS₂), NbS₂ ou TaS₂ figurent parmi les métaux les plus performants pour contacter MoS₂ ou WS₂ avec une faible résistance de contact. Ils présentent également l'avantage d'être très similaires à MoS₂ et WS₂ à la fois sur le plan chimique et cristallographique, et donc de former une interface franche, peu stressée, thermiquement stable, et exempte d'autres hétéroéléments tels que l'oxygène ou l'azote qui pourraient altérer les propriétés du TMD. Enfin, les éléments du groupe 5 (V, Nb, Ta) permettent d'induire un dopage de type p dans les TMDs semiconducteurs du groupe 6 (MoS₂ et WS₂, naturellement dopés n par la présence de lacunes en soufre) et de contrôler ainsi la polarité des porteurs de charge.

Actuellement, deux voies principales d'élaboration de couches minces de sulfure de métaux de transition existent.

Une première voie consiste à déposer le matériau par dépôt chimique en phase vapeur (ou CVD pour 'Chemical Vapor Deposition') .

Par exemple, dans la demande US 2019/0378898 A1, la CVD est utilisée pour déposer des couches de MoS₂ et WS₂. Les précurseurs sont, par exemple, Mo(CO)₆ et W(CO)₆ et le sulfure de diéthyle.

Cependant, avec les dépôts par CVD, il est difficile d'obtenir un bon contrôle de la nucléation et donc de l'uniformité de la couche déposée. De plus, il n'est pas possible de déposer des couches de TMDs sur des substrats ayant des architectures à fort facteur de forme (dans des nano-cavités par exemple) . L'introduction de métaux du groupe 5 en tant que dopant ou la réalisation d'hétérostructures de TMDs des groupes 5 et 6 est également difficile à mettre en oeuvre en CVD car les conditions de dépôt visent directement la formation de cristaux ayant la bonne phase cristalline, et chaque matériau va nécessiter un ajustement bien précis de la température et des pressions partielles en réactifs.

Une deuxième voie consiste à déposer le matériau par dépôt de couches atomiques (ALD pour 'Atomic Layer Deposition') . Pour ce type de dépôt, les précurseurs sont utilisés séquentiellement et non en mélange comme dans le cas d'un dépôt par CVD. Les dépôts par ALD permettent d'avoir une bonne maîtrise de l'uniformité même dans des architectures à fort facteur de forme, et autorisent plus facilement que la CVD la formation d'hétérostructures ou le mélange de plusieurs métaux pour former des alliages de composition bien définie. Cependant, afin d'assurer une croissance uniforme de couches de TMDs ultra-minces (typiquement inférieures à 5 nm) et continues par ALD, le matériau doit être déposé amorphe (donc à basse température), ce qui implique la nécessité d'une étape de recuit de cristallisation post-dépôt. Le matériau obtenu par ce procédé en 2 étapes présente typiquement une taille de grain inférieure aux matériaux obtenus par croissance CVD. Éventuellement, une étape de sulfuration thermique avant ou pendant le recuit permet de corriger si nécessaire la stoechiométrie du TMD.

Par exemple, le document US 2015/0211112 A1 décrit le dépôt de MoS₂ par ALD. Les précurseurs de Mo sont des composés mono-métalliques ou bi-métalliques non halogénés. Ces composés sont non halogénés. Le co-réactant soufré est H₂S ou 1,2-éthanedithiol. Un recuit de cristallisation optionnel peut être implémenté après le dépôt.

Selon un autre exemple, le document US 11,142,824 B2 décrit le dépôt d'une couche de molybdène métal par ALD à basse température (inférieure à 300°C) en utilisant le couple de précurseurs MoF₆/Si₂H₆. La couche de molybdène est ensuite convertie en MoS₂ par un traitement thermique de sulfuration sous H₂S à une température comprise entre 300 et 600°C.

Dans le document US 9, 863, 039 B2 une couche de MoS₂ est formée en déposant séquentiellement les précurseurs Mo(CO)₆ et le sulfure de diméthyle à une température de 100-120°C. Le traitement thermique pour cristalliser la couche de MoS₂ est effectué à une température comprise entre 400 et 1000°C.

Le document WO 2016/191432 A1 décrit un procédé de dépôt par ALD de couches de TMDs, en particulier des sulfures, séléniures et tellurures de Mo et W. Les précurseurs de Mo et W sont des beta-dicétonates, et les précurseurs des chalcogènes sont, par exemple, H₂S, H₂Se ou H₂Te, Me₂S, Me₂Se et Me₂Te. La température de dépôt est de préférence entre 250 °C et 600 °C. Plusieurs dépôts ALD ont été réalisés en utilisant les précurseurs Mo(thd)₃ et H₂S avec des températures de dépôt allant de 175°C à 500°C. Aucun dépôt de MoS₂ n'a été observé à des températures de dépôt entre 175°C et 350°C. La quantité de film déposée sur les substrats semble augmenter à partir de 375 °C. Les taux de croissance les plus élevés ont été obtenus à une température de dépôt d'environ 500°C.

On peut cependant noter que les températures de dépôt utilisées dans certains de ces procédés peuvent conduire à la croissance d'un matériau directement cristallin (typiquement lorsque la température de dépôt est supérieure à 150-200°C), ce qui n'est pas optimal pour l'obtention de couches ultra-minces (présentant une épaisseur inférieure à 5 nm), lisses (peu rugueuses) et continues.

De plus, la majorité de ces procédés ne permettent pas le dépôt d'hétérostructures ou d'alliages associant des métaux de transition des groupes 5 et 6.

### Résumé de l'invention

Il existe un besoin d'avoir un procédé de dépôt permettant de former une couche de sulfure de métal de transition ou d'un de ses alliages présentant une faible rugosité et une bonne qualité cristalline.

Ce but est atteint par un procédé de dépôt en phase vapeur d'une couche en sulfure d'un métal de transition ou d'un de ses alliages, le procédé comprenant une étape de dépôt de couches atomiques selon le cycle suivant :
- exposer un substrat à un précurseur d'un métal de transition, moyennant quoi une couche intermédiaire est formée sur le substrat,
- purger le réacteur,
- exposer la couche intermédiaire à un précurseur du soufre,
- purger le réacteur,

le substrat étant à une température comprise entre 20°C et 250°C lors du cycle,
le cycle pouvant être répété plusieurs fois, le précurseur du métal de transition et/ou le précurseur du soufre pouvant être identiques ou différents lors des répétitions du cycle,
le précurseur du métal de transition étant choisi parmi les oxyhalogénures de molybdène, les oxyhalogénures de tungstène, les halogénures de vanadium, les halogénures de niobium et les halogénures de tantale.

Selon un mode de réalisation particulier, le précurseur du métal de transition est choisi parmi MoO₂Cl₂, MoOCl₄, WOCl₄, VCl₄, NbCl₅ et TaCl₅.

Selon un mode de réalisation particulier, le précurseur du soufre est choisi parmi le sulfure d'hydrogène, les polysulfures d'hydrogène et les thiols, de préférence les dithiols.

Selon un mode de réalisation particulier, le précurseur du soufre est choisi parmi le 1,2-éthanedithiol, le 1,2-propanedithiol et le 1,3-propanedithiol.

Selon un mode de réalisation particulier, après l'étape de dépôt de couches atomiques, le procédé comprend une étape de sulfuration au cours de laquelle le substrat est exposé à une molécule soufrée possédant au moins une liaison soufre-hydrogène ou soufre-carbone, à une température comprise entre 250°C et 1150°C, de préférence entre 300°C et 400°C.

Avantageusement, la molécule soufrée est un dithiol, de préférence le 1,2-éthanedithiol.

Selon un mode de réalisation particulier, après l'étape de dépôt de couches atomiques, ou après l'étape de sulfuration, une étape de recuit est mise en oeuvre.

Avantageusement, l'étape de recuit est réalisée sous atmosphère inerte à une température comprise entre 400 °C et 1150 °C, de préférence entre 650 °C et 950 °C.

Selon un mode de réalisation particulier, le substrat est à une température comprise entre 50 °C et 150 °C, de préférence entre 80 °C et 120 °C, lors du cycle.

Selon un mode de réalisation particulier, le précurseur du métal de transition est choisi parmi MoO₂Cl₂, MoOCl₄, WOCl₄ et VCl₄ et en ce que le précurseur du soufre est le 1,2-éthanedithiol.

Ce but est également atteint par un dispositif comprenant un substrat recouvert par une couche mince cristalline en sulfure de molybdène, de tungstène, de vanadium, de niobium, de tantale ou en un de leurs alliages comme Mo(V)S₂ ou W(V)S₂, la couche mince ayant une épaisseur inférieure à 100 nm, de préférence inférieure à 20 nm, encore plus préférentiellement inférieure à 10 nm, les cristaux de la couche mince étant orientés, leur plan cristallographique (001) étant parallèle au plan du substrat.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

- la figure 1 est un schéma fonctionnel d'un cycle ALD selon un mode de réalisation particulier de l'invention,

- la figure 2 est une image STEM (HAADF) d'une hétérostructure MoS₂ (1 nm) / VSₓ (5 nm) obtenue selon un mode de réalisation particulier du procédé.

### Description des modes de réalisation

Sauf précision contraire, l'expression comme "environ" signifie à 10 % près, de préférence à 5 % près, et l'expression "compris entre ... et ... " signifie que les bornes sont incluses.

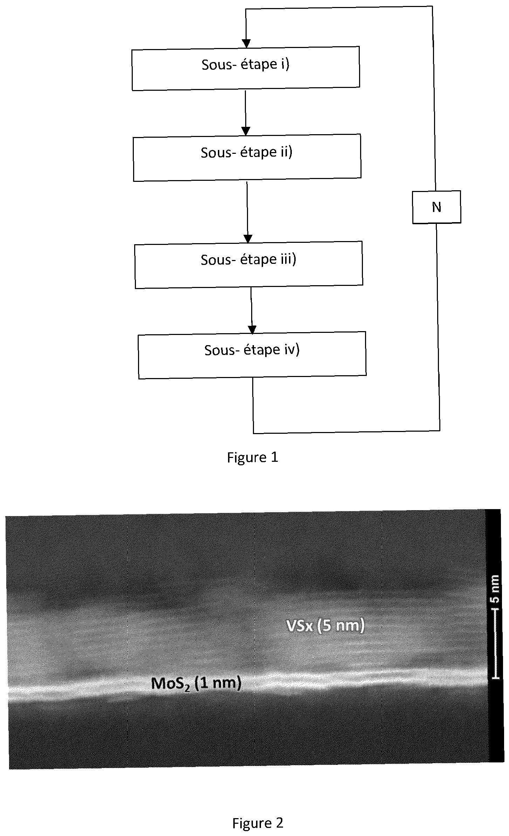

Nous allons maintenant décrire plus en détail le procédé de dépôt par couches atomiques (ALD) d'une couche mince en sulfure d'un métal de transition ou en sulfure d'un alliage de métaux de transition. Le procédé comprend les étapes suivantes :
a) réaliser le cycle de dépôt ALD selon les sous-étapes suivantes (figure 1) :
   - exposer un substrat à un précurseur du métal de transition, moyennant quoi une couche intermédiaire est formée sur le substrat (sous-étape i)),
   - purger le réacteur (sous-étape ii)),
   - exposer le substrat et la couche intermédiaire à un précurseur du soufre (sous-étape iii)), moyennant quoi une couche en sulfure d'un métal de transition est formée,
   - purger le réacteur (sous-étape iv)),
b) de préférence, réaliser une étape de sulfuration, par exemple à une température supérieure à 250 °C,
c) de préférence, réaliser un recuit, avantageusement, sous atmosphère inerte, et de préférence à une température supérieure à 400 °C.

L'étape b) de sulfuration et l'étape c) de recuit peuvent être une seule et même étape.

Le cycle de dépôt peut être répété N fois, avec N un entier (figure 1). Autrement dit, la séquence formée des sous-étapes i), ii), iii) et iv) peut être répétée N fois.

Toute la séquence ALD est réalisée à basse température, c'est-à-dire à une température de dépôt inférieure à 250 °C, et de préférence à une température de dépôt comprise entre 20 et 250 °C, encore plus préférentiellement entre 50 et 250 °C, encore plus préférentiellement entre 50 et 200 °C, et de manière encore plus préférentielle entre 80 et 150 °C. La température de dépôt correspond à la température du substrat.

De telles températures assurent la croissance d'une couche amorphe en régime ALD. La couche déposée est ainsi parfaitement uniforme et peu rugueuse. L'épaisseur et la morphologie de la couche sont, avantageusement, identiques en tout point du substrat. La faible rugosité garantit que chaque cristal qui sera formé dans la couche à l'issue du procédé aura la même épaisseur et qu'il n'y aura pas de fracture ou discontinuité dans le dépôt.

Les faibles vitesses de croissance lors d'un dépôt par ALD permettent un meilleur contrôle de la composition de la couche dans le cas de la formation d'alliages avec les métaux de transition du groupe 5 (V, Nb, Ta).

Ainsi, le procédé de dépôt par ALD permet, non seulement, de faire croître un TMD dans des cavités à fort facteur de forme, mais également de maîtriser la formation d'un alliage ou d'une hétérostructure. En effet, avec un tel procédé, il est possible, dans un premier temps, de déposer les différents matériaux en couches successives ou en alliage, puis de réaliser la cristallisation simultanée des différents matériaux dans un second temps.

En CVD, il est plus difficile d'obtenir des alliages de composition contrôlée car les précurseurs sont introduits en mélange et seule la composition thermodynamiquement la plus stable dans les conditions de température et de pressions partielles utilisées pour le dépôt est obtenue.

Lors de l'étape a), et plus particulièrement lors de la sous-étape i), le précurseur du métal de transition est choisi dans la famille des oxyhalogénures pour les métaux de transition du groupe 6 ayant typiquement pour formule MO₂X₂ ou MOX₄ (X = F, Cl, Br, I) ou dans la famille des halogénures pour les métaux de transition du groupe 5 ayant typiquement pour formule MXₙ (avec n compris entre 3 et 5 et X = F, Cl, Br, I).

De manière préférentielle, il est choisi parmi les oxychlorures de molybdène, les oxychlorures de tungstène, les chlorures de vanadium, les chlorures de niobium et les chlorures de tantale.

De tels précurseurs sont moins onéreux que d'autres précurseurs de l'art antérieur (par exemple les amidures ou les organométalliques). En outre, leur plus grande stabilité thermique permet la mise en oeuvre du procédé dans des réacteurs de type « batch », plus adaptés à une production à grande échelle.

La pression de vapeur saturante (Vp) du précurseur du métal M sera avantageusement supérieure à 0,1 torr, et encore plus préférentiellement supérieure à 1 Torr, à la température utilisée pour le procédé de dépôt afin d'assurer un transport de masse suffisant vers le réacteur.

De préférence, le précurseur est choisi parmi MoO₂Cl₂, MoOCl₄, WOCl₄, VCl₄, NbCl₅ et TaCl₅. Ces précurseurs répondent au critère de volatilité précédemment mentionné (Vp > 0,1 torr à la température de dépôt).

À l'issue de la sous-étape i), une couche intermédiaire comprenant le métal de transition ou une molécule intermédiaire comprenant le métal de transition est formée sur le substrat. Cette couche intermédiaire réagira avec la molécule soufrée lors de la sous-étape iii).

Lors de la sous-étape iii), le précurseur du soufre est choisi parmi le sulfure d'hydrogène, un polysulfure d'hydrogène, un composé organosoufré contenant, de préférence, au moins 2 liaisons soufre-hydrogène ou de toute autre système permettant la formation *in situ* des précurseurs mentionnés (générateur plasma ou unité dite de pré-craquage thermique ('pré-cracking' ) par exemple).

De préférence, le précurseur du soufre est choisi parmi le sulfure d'hydrogène, un polysulfure d'hydrogène et les thiols, de préférence les dithiols.

Encore plus préférentiellement, le dithiol est choisi parmi le 1,2-éthanedithiol, le 1,2-propanedithiol et le 1,3-propanedithiol.

Les précurseurs du métal de transition ou du soufre peuvent être sous forme solide, liquide ou gazeux. Les précurseurs sous forme solide ou liquide sont stockés dans un saturateur en inox.

De préférence, les précurseurs sont introduits dans le réacteur sous forme de vapeur (gaz). La température à laquelle les précurseurs sont chauffés dans le saturateur dépend de leur volatilité. La température sera choisie de manière à atteindre une tension de vapeur suffisante pour alimenter le réacteur (typiquement environ 0,1 à 5 torr, c'est-à-dire entre 13, 3 et 666,6 Pa environ) .

Il est possible de réaliser le cycle ALD avec les mêmes précurseurs ou avec des précurseurs différents lors des différentes répétitions du cycle.

Par exemple, pour former des alliages Mo(V)S₂ ou des hétérostructures MoS₂/VS₂, lors du cycle ALD, les couples de précurseurs MoO₂Cl₂/EDT et/ou VCl₄/EDT peuvent être utilisés.

La température de dépôt de VS₂ est, de préférence, identique à la température de dépôt de MoS₂ (inférieure à 150°C) et le même précurseur de soufre (EDT) est utilisé, ce qui permet la réalisation de séquences de dépôt de Mo(V)S₂ où la proportion de vanadium peut être parfaitement contrôlée.

De préférence, le précurseur de soufre est identique tout au long du procédé. De préférence, il s'agit du 1,2-éthanedithiol (EDT).

Le cycle ALD est mis en oeuvre dans un réacteur permettant l'envoi séquentiel des précurseurs. Les précurseurs ne sont pas introduits de manière concomitante. Une purge (sous-étapes ii) et iv)) est réalisée entre chaque introduction de précurseurs pour évacuer les précurseurs n'ayant pas réagi lors de la sous-étape précédente ainsi que les sous-produits de réaction volatils. La purge est réalisée avec un gaz neutre, comme de l'argon ou de l'azote.

La pression de travail est, de préférence comprise entre 1 mtorr et 50 torr (soit entre 0,1 Pa et 6666, 1 Pa environ), et encore plus préférentiellement entre 0,1 et 10 torr. La pression de travail peut varier selon le volume et le dimensionnement du réacteur.

Le substrat est, par exemple, un substrat en silicium (notamment une plaque de silicium (`wafer')) recouvert d'une couche mince de silice ou de tout autre matériau oxide, nitrure ou métal présentant une faible rugosité de surface et ne réagissant pas avec la couche de TMD déposée ou les réactifs utilisés lors des étapes de dépôt, sulfuration ou recuit. Alternativement, la croissance peut se faire sur un autre TMD (sulfure, séléniure ou tellure). La surface exposée du substrat peut présenter différentes zones composées des différents matériaux précédemment cités en vue de l'intégration de la couche de TMD dans un dispositif microélectronique.

Comme évoqué précédemment, le dépôt obtenu à l'issue de l'étape a) est amorphe. Il s'agit d'un polymère de coordination contenant des liaisons métal-soufre ainsi que des ligands 1,2-éthanedithiolato. Un tel polymère est converti en une couche de sulfure très uniforme lors de l'étape de recuit (étape c).

À l'issue de l'étape a), en fonction de la température et des réactifs utilisés lors du cycle ALD, la couche mince obtenue peut encore contenir des ligands non substitués ou du carbone présent dans le précurseur du soufre. L'étape optionnelle de sulfuration (étape b) pouvant être mise en oeuvre avant ou pendant l'étape c)) permet de garantir l'élimination des ligands résiduels, autrement dit que la couche mince soit exclusivement constituée de liaisons métal-soufre, et l'obtention d'un sulfure présentant la bonne stoechiométrie. Un autre avantage de l'étape de sulfuration est de pré-cristalliser la couche mince de TMD et lui conférer ainsi une meilleure stabilité à l'air qui permet de limiter la formation de liaisons métal-oxygène lors du transfert vers l'équipement de recuit thermique, et/ou le cas échéant lors des étapes de nettoyage de la face arrière du substrat.

La température de l'étape b) est, de préférence, à une température supérieure à 250°C, de préférence à une température comprise entre 250 et 1150 °C, encore plus préférentiellement entre 300 et 400 °C.

L'étape de sulfuration est réalisée en présence d'un composé soufré. Les précurseurs utilisés pour cette étape peuvent être le soufre sous sa forme native ou n'importe quelle molécule volatile contenant des liaisons S-H ou S-C, utilisée sous forme de vapeur diluée dans un gaz inerte, ou en mélange avec de l'hydrogène.

De préférence, il peut s'agir de la même molécule soufrée que celle utilisée lors de l'étape de dépôt, ce qui permet alors de réaliser l'étape de sulfuration directement dans l'équipement utilisé pour le dépôt, sans remise à l'air. Par exemple, la sulfuration de la couche mince obtenue avec le couple de précurseurs MoO₂Cl₂/EDT pour former MoS₂ peut être réalisée de manière optimale à 360°C sous vapeur d'EDT pendant une durée de 30min.

L'étape b) de sulfuration peut être directement appliquée sur l'alliage ou l'hétérostructure finale. Il n'y a pas besoin de répéter une étape de sulfuration distincte entre chaque couche d'un métal différent. En effet, la diffusion du soufre dans une couche amorphe de TMD est largement suffisante pour assurer la sulfuration de couches minces d'une dizaine de nanomètres d'épaisseur en quelques minutes.

La mise en oeuvre de l'étape c) dépend des températures mises en oeuvre lors des étapes a) et/ou b).

L'étape c) de recuit thermique permet de faire cristalliser la couche mince de TMDs et/ou d'améliorer sa qualité cristalline. Elle assure la formation de cristaux de TMDs orientés dans le plan du substrat et de taille optimale.

Cette étape est réalisée, de préférence, sous atmosphère inerte (N₂, He ou Ar, notamment)

Ce recuit est réalisé à une température supérieure à la température mise en oeuvre lors de l'étape b) de sulfuration. Le recuit est, typiquement, effectué à une température comprise entre 400 et 1150°C, idéalement entre 650°C et 950°C.

Par exemple, la température de l'étape c) est avantageusement de 900°C pour du MoS₂ ou WS₂, comme par exemple dans le cas où l'application visée requiert une cristallinité optimale du TMD.

La source de chaleur peut être une résistance ou n'importe quelle autre source émissive (lampe halogène ou laser) pouvant être absorbée par la couche mince de TMD ou tout autre constituant du substrat de croissance.

Avec un tel procédé, il est possible de fabriquer des couches minces de MS₂ ou M'Sx avec M un métal de transition du groupe 6 et M' un métal de transition du groupe 5, des alliages de type M(M')S₂ , ou encore des hétérostructures constituées d'un empilement de différents matériaux TMD (MS₂/M'Sₓ par exemple).

Plus particulièrement, le dispositif obtenu comprend un substrat recouvert par une couche mince ou un empilement de couches minces cristallines en sulfure de molybdène, de tungstène, de vanadium (VS₂ ou VSₓ avec x strictement supérieur à 1 et strictement inférieur à 3), de niobium, de tantale ou d'un de leurs alliages comme Mo(V)S₂ ou W(Nb)S₂.

Avec un tel procédé, il est possible d'obtenir des couches de différentes épaisseurs en fonction de l'application visée.

La couche mince peut avoir une épaisseur allant jusqu'à 50 nm voire jusqu'à 100 nm, notamment pour former des contacts en TMDs métalliques (groupe 5).

La couche mince peut avoir une épaisseur plus faible. Par exemple, il peut s'agir d'une épaisseur inférieure à 20 nm, de préférence inférieure à 10 nm.

L'épaisseur minimale de la couche mince peut correspondre à l'épaisseur d'une monocouche atomique selon le plan 001, soit par exemple 0,65nm pour une monocouche de MoS₂.

Les couches minces obtenues peuvent présenter une très faible rugosité. La rugosité RMS (déterminée par AFM) peut être typiquement inférieure à 0,3nm.

Le procédé est particulièrement intéressant car il permet d'obtenir des couches ultra-minces (typiquement ayant une épaisseur inférieure à 5nm), lisses (peu rugueuses ; typiquement ayant une rugosité inférieure à 0,3nm) et continues.

Les plans (001) des cristaux de TMD sont orientés parallèlement au plan du substrat.

Le procédé est facilement industrialisable en raison de son faible coût et de la stabilité thermique des précurseurs utilisés.

Le procédé est particulièrement intéressant pour fabriquer des dispositifs (micro)électroniques tels que des transistors à effets de champ, memristors, interrupteurs radiofréquences (`switches RF'), et des dispositifs pour la spintronique ou l'informatique quantique.

Le vanadium, le niobium et le tantale permettent d'induire un dopage de type p robuste dans les matériaux en MoS₂ et WS₂. De plus, VS₂ présente un accord de maille quasi-idéal avec MoS₂ et WS₂.

Il est ainsi possible de former des hétérostructures VS₂/MoS₂ ou VS₂/WS₂ très peu contraintes ou des alliages semiconducteurs Mo(V)S₂ ou W(V)S₂ pouvant présenter des propriétés de conduction plus intéressantes que MoS₂ et WS₂ purs.

Les sulfures lamellaires de vanadium (VS₂ et V₅S₈) sont de bons conducteurs (résistivités inférieures au mOhm.cm). En particulier, VS₂ présente une plus faible résistance de contact sur MoS₂. L'implémentation d'un contact à base de sulfure est également particulièrement intéressante pour ne pas endommager un semiconducteur TMD à base de MoS₂ ou WS₂.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

### Exemples illustratifs et non limitatifs de différents modes de réalisation

### Exemple 1 : Dépôt d'une couche de MoS₂

Le cycle ALD est réalisé en alternant successivement des pulses des précurseurs MoO₂Cl₂ et EDT (1,2-éthanedithiol) à 100°C.

La température de la source MoO₂Cl₂ est de 68°C. la température de la source EDT est de 40°C.

Après la formation de la couche mince, une étape de sulfuration est réalisée en présence d'EDT pendant 30 min à 360°C. Un recuit thermique rapide (RTP) sous N₂ pendant 30 secondes à 900°C conduit à la cristallisation de la couche mince de MoS₂.

### Exemple 2 : Dépôt d'une couche de sulfure de vanadium

Le cycle ALD est réalisé en alternant successivement des pulses des précurseurs VCl₄ et EDT (1,2-éthanedithiol) à 100°C.

La température de la source VCl₄ est de 30°C. La température de la source EDT est de 40°C.

Après la formation de la couche mince, une étape de sulfuration est réalisée en présence d'EDT pendant 30 min à 360°C, sans remise à l'air entre les étapes de dépôt et de sulfuration.

La résistivité de la couche de sulfure de vanadium obtenue après sulfuration est d'environ 1000 pOhm.cm pour 10 nm d'épaisseur.

Un recuit thermique après l'étape de sulfuration permet de cristalliser le matériau et de lui conférer une meilleure résistance à l'oxydation. Le matériau conserve des propriétés métalliques pour des températures de recuit allant jusqu'à 950°C avec une variation non linéaire de la résistivité.

### Exemple 3 : Dépôt d'une couche de Mo(V)S₂ (sulfure de molybdène dopé vanadium)

La couche est obtenue par ALD en utilisant les précurseurs MoO₂Cl₂, VCl₄ et EDT (1,2-éthanedithiol) à une température de 100 °C. Les précurseurs sont introduits selon la séquence [(MoO₂Cl₂/EDT)_{X}/(VCl₄/EDT)]_{Y} avec x et y des entiers positifs.

La température de la source MoO₂Cl₂ est de 68°C. La température de la source VCl₄ est de 30°C. La température de la source EDT est de 40°C.

Après la formation de la couche mince, une étape de sulfuration est réalisée en présence d'EDT pendant 30 min à 360°C.

Un recuit thermique rapide (RTP) sous N₂ pendant 30 secondes à 900°C conduit à la cristallisation de la couche mince de Mo(V)S₂. La résistivité de la couche de MoS₂ est d'autant plus faible que la quantité de vanadium incorporé est importante.

### Exemple 4 : formation d'une hétérostructure MoS₂ / VSx

Les couches de l'hétérostructure ont été déposées par ALD à 100°C en aboutant les séquences décrites dans les exemples 1 et 2 et en ajustant le nombre de cycle ALD pour obtenir 2 monocouches atomiques de MoS₂ recouvertes de 5nm de sulfure de vanadium. L'hétérostructure a ensuite été sulfurée à 350°C et cristallisée par recuit thermique rapide à 850°C.

L'hétérostructure obtenue a été caractérisée par microscopie électronique en transmission (STEM-HAADF), mettant ainsi en évidence la formation d'un empilement MoS₂ (1 nm) / VSₓ (5 nm) (figure 2).

## Revendications

1. Procédé de dépôt en phase vapeur d'une couche en sulfure d'un métal de transition ou d'un de ses alliages pour la formation d'hétérostructures MS₂/M'Sx ou d'alliages M(M')S₂ avec M un métal de transition du groupe 6 et M' un métal de transition du groupe 5, le procédé comprenant une étape de dépôt de couches atomiques selon le cycle suivant :
- exposer un substrat à un précurseur d'un métal de transition, moyennant quoi une couche intermédiaire est formée sur le substrat,
- purger le réacteur,
- exposer la couche intermédiaire à un précurseur du soufre,
- purger le réacteur,
le substrat étant à une température comprise entre 20°C et 250°C lors du cycle,
le cycle pouvant être répété plusieurs fois, le précurseur du métal de transition et/ou le précurseur du soufre pouvant être identiques ou différents lors des répétitions du cycle,
le précurseur du métal de transition étant choisi parmi les oxyhalogénures de molybdène, les oxyhalogénures de tungstène, les halogénures de vanadium, les halogénures de niobium et les halogénures de tantale.

2. Procédé selon la revendication 1, **caractérisé en ce que** le précurseur du métal de transition est choisi parmi MoO₂Cl₂, MoOCl₄, WOCl₄, VCl₄, NbCl₅ et TaCl₅.

3. Procédé selon l'une des revendications précédentes, **caractérisé en ce que** le précurseur du soufre est choisi parmi le sulfure d'hydrogène, les polysulfures d'hydrogène et les thiols, de préférence les dithiols.

4. Procédé selon l'une quelconque des revendications précédentes, **caractérisé en ce que** le précurseur du soufre est choisi parmi le 1,2-éthanedithiol, le 1,2-propanedithiol et le 1,3-propanedithiol.

5. Procédé selon l'une quelconque des revendications précédentes, **caractérisé en ce que**, après l'étape de dépôt de couches atomiques, le procédé comprend une étape de sulfuration au cours de laquelle le substrat est exposé à une molécule soufrée possédant au moins une liaison soufre-hydrogène ou soufre-carbone, à une température comprise entre 250°C et 1150°C, de préférence entre 300°C et 400°C.

6. Procédé selon la revendication précédente, **caractérisé en ce que** la molécule soufrée est un dithiol, de préférence le 1,2-éthanedithiol.

7. Procédé selon l'une quelconque des revendications précédentes, **caractérisé en ce que**, après l'étape de dépôt de couches atomiques, ou après l'étape de sulfuration, une étape de recuit est mise en oeuvre.

8. Procédé selon la revendication précédente, **caractérisé en ce que** l'étape de recuit est réalisée sous atmosphère inerte à une température comprise entre 400 °C et 1150 °C, de préférence entre 650 °C et 950 °C.

9. Procédé selon l'une quelconque des revendications précédentes, **caractérisé en ce que** le substrat est à une température comprise entre 50 °C et 150 °C, de préférence entre 80 °C et 120 °C, lors du cycle.

10. Procédé selon l'une quelconque des revendications précédentes, **caractérisé en ce que** le précurseur du métal de transition est choisi parmi MoO₂Cl₂, MoOCl₄, WOCl₄ et VCl₄ et **en ce que** le précurseur du soufre est le 1,2-éthanedithiol.

11. Dispositif comprenant un substrat recouvert par un empilement de couches minces cristallines formant une hétérostructure MS₂/M'Sx ou par une couche mince cristalline en un alliage M(M')S₂ avec M un métal de transition du groupe 6 et M' un métal de transition du groupe 5, la ou les couches minces cristallines étant en sulfure de molybdène, de tungstène, de vanadium, de niobium, de tantale ou en un de leurs alliages comme Mo(V)S₂ ou W(V)S₂, la ou les couches minces ayant une épaisseur inférieure à 100 nm, de préférence inférieure à 20 nm, encore plus préférentiellement inférieure à 10 nm, les cristaux de la ou des couches minces étant orientés, leur plan cristallographique (001) étant parallèle au plan du substrat.
